# EUROPEAN PATENT SPECIFICATION

(11) **EP 2 259 310 B1**
(45) Date of publication and mention of the grant of the patent: **08.04.2020**
(21) Application number: 09007474.1
(22) Date of filing: 05.06.2009
(51) Int. Cl.: H01L 23/467, H01L 23/473, H05K 7/20, H01L 25/07

(54) **Integrated heat exchanger**
Integrierter Wärmetauscher
Échangeur de chaleur intégré

(43) Date of publication of application: 08.12.2010
(73) Proprietor: Siemens Gamesa Renewable Energy A/S, 7330 Brande (DK)
(72) Inventor: Jones, Rodney, Audley ST7 8DL Stoke on Trent (GB); Waite, Philip Perry, ST5 5EW Maer Hills,Newcastle Staffordshire (GB)
(74) Representative: Aspacher, Karl-Georg

(56) References cited:
- EP-A- 1 770 774
- EP-A- 1 830 406
- US-A- 5 109 317
- US-A- 6 125 036
- US-A1- 2002 021 557
- US-A1- 2003 048 608
- US-A1- 2005 024 830
- US-A1- 2005 042 082
- US-A1- 2005 103 475
- US-A1- 2007 227 707
- US-A1- 2007 227 708
- US-B1- 6 367 544

## Description

### Field of invention

The present invention relates to the field of a heat exchanger for electronic components. Moreover, the present invention relates to an electronic cubicle device and to a method of cooling an electronic component.

### Art background

In sealed electronic cubicles, such as sealed frequency converter cubicles, internal electronic components produce heat that has to be collected and extracted to be dissipated elsewhere. Some electronic components may be water cooled whereas other electronic components, such as small electronic component parts or electronic conductors, are air cooled, because it may be difficult to provide a water cooling for all electronic components.

Today, typical electronic cubicles comprise two cooling systems which are integrated into the cubicles. A water cooling system is provided for cooling e.g. the larger electronic components, such as power semi-conductor devices, for example insulated-gate bipolar transistors (IGBTs) and a further cooling system that is adapted for cooling the air inside the cubicle that is heated up by further smaller electronic components that are not easily or economically coolable by the water cooling system. Thus, two separate cooling systems with different and separated pipework connections have to be provided.

It is further difficult to provide a cooling system for sealed electronic cubicles. It is desirable to seal the electronic cubicles to an IP55 or better environmental protection standard (IP code; international protection rating, e.g. according to international standard IEC 60529). Thus, an air exchange of the internal air of the electronic cubicle with the environment external to the electronic cubicle should be prevented. Such sealed electronic cubicles are useful to maintain a micro-environment for a plurality of electrical systems in order to protect the electrical systems from influences from the environment external to the sealed electronic cubicle itself.

Because of the sealed micro-environment inside the electronic cubicles, the electronic cubicles are usable in arduous environments, for example offshore wind turbine systems, because the micro-environment inside such a sealed cubicle may be free of condensation and salt that may be present in the environment outside the cubicle.

In conventional electronic cubicles, a first heat load, that is generated by a water cooled electronic component, e.g. by a power semi-conductor devices, may be cooled by a water cooling system. The electronic components may be mounted to a chill plate that includes cooling channels comprising a coolant for cooling the electronic components.

The other electronic components that are not economically of viably cooled by the water cooling systems have to be cooled by cooling air through an air to water heat exchanger using a fan. The other electronic components may be for instance current carrying bus bars, fuses, switchgear components, control electronic assemblies, printed circuit boards, etc. Because these electronic components are difficult to directly water cooled, the fan of the air cooled heat exchanger provides an air circulation. The generated heat load is transferred to the air cooler wherein the air transfers the heat to the air cooled heat exchanger.

In conventional electronic cubicles both the chill plate and the air to water heat exchanger are placed in series or parallel and a pump pumps liquid coolant to a further heat exchanger external to the electronic cubicle. When placing the above described two cooling systems in series, at least 4 to 6 liquid interfaces have to be provided. For example, liquid connections have to be provided to the air-cooled heat exchanger and further liquid connections have to be provided to the chill plate. Moreover, further liquid connections have to be provided to feed and to drain a coolant inside or out of the electronic cubicle. Thus, a complex line system has to be provided for installing a cooling system for all electronic components.

US 2002/0021557 A1 discloses an electronic apparatus including a motherboard, a plurality of multi-chip modules mounted to the motherboard and cooling members for cooling the multi-chip modules. A refrigeration unit is arranged to deliver cooling water to the cooling members. A connection structure is provided for each multi-chip module for thermally and mechanically releasably coupling each multi-chip module to the refrigeration unit.

EP 1 830 406 A1 discloses a power module whose production cost can be kept low. A power module comprises a power semiconductor, a non-power semiconductor, one resin substrate, and cooling means. The power semiconductor and the non-power semiconductor configure a power supply circuit for performing power conversion. Both the power semiconductor and the non-power semiconductor are mounted on the resin substrate. The cooling means is disposed in order to cool the power semiconductor.

EP 1 770 774 A2 discloses a heatsink assembly having a simple structure for coupling a heatsink and an electronic chip which is provided with a heatsink which contacts a heat source mounted on a substrate and absorbs heat generated from the heat source. The heatsink comprises a pressing member which is coupled to the substrate and comprises a pressing cover for pressing the heatsink so that the heatsink can be secured to the heat source and tension parts which extend from the pressing cover and exert a pressing force onto the pressing cover, when being coupled to the substrate.

US 2007/0227708 A1 discloses an integrated cooling system for cooling systems such as laptops or subsystems such as a graphics card. An integrated cooling system includes a first layer having a contact area configured for coupling to a heat source, wherein the first layer has a fluid path passes adjacent to the contact area where the heat source is in thermal contact with first layer. Coupled to the first layer is a second layer to which a number of air fins are attached. The integrated cooling system includes a pump that is connected to the fluid path forming a closed path for circulating a fluid through the first layer. Within the first layer, the fluid path will contain a plurality of fluid fins which control the flow of a fluid within the fluid path. Within the fluid path, a structure providing a double-counter flow adjacent to one or more electronic devices. Additionally, the fluid path can include a microchannel plate structure. The system can include a includes a programmable controller connect an air-mover, pump and temperature sensing device. A reservoir can be connected to the fluid path.

### Summary of the Invention

It may be an object of the present invention to provide a proper and simple cooling system for electronic components.

In order to achieve the object defined above, an electronic cubicle device and a method of cooling an electronic component according to the independent claims are provided.

According to a first exemplary embodiment of the present invention, an electronic cubicle device comprising a first electronic component, a second electronic component, and a cooling device is provided. The cooling device comprises a heat exchanger body comprising a cooling channel for a coolant, a mounting surface to which the first electronic component is mounted and an outer heat exchange surface. The cooling device further comprises a feeding line connection for feeding the coolant and a draining line connection for draining the coolant. Further, the electronic cubicle device comprises an air source connected to the heat exchanger body and an air guiding element connected to the heat exchanger body and/or to the air source. The cooling channel is interconnected to the feeding line connection and the draining line connection. The cooling channel is formed within the heat exchanger body in such a way that the coolant in the cooling channel is in thermal contact with the mounting surface and the outer heat exchange surface for providing a heat exchange. The air source is adapted for providing an air circulation of air surrounding the cooling device, so that an air flow of the air surrounding the cooling device is provided at the outer heat exchange surface. The air guiding element is adapted for guiding the air flow of the air surrounding the cooling device to the outer heat exchange surface. The first electronic component is attached to the mounting surface of the cooling device. The second electronic component is mounted to another location than the mounting surface within the electronic cubicle device in such a manner that a lost heat of the second electronic component is transferred to the air surrounding the cooling device. The outer heat exchange surface of the cooling device is adapted for providing a heat exchange with the air surrounding the cooling device.

Moreover, according to a further exemplary embodiment of the present invention, an electronic cubicle device is provided, comprising a cooling device as described above, the first electronic component and a second electronic component. The first electronic component is attached to the mounting surface of the cooling device, wherein the second electronic component is located within the electronic cubicle device in such a manner that the heat load of the second electronic component is transferred to the air surrounding the cooling device and wherein the outer heat exchange surface of the cooling device is adapted for providing a heat exchange with the air surrounding the cooling device.

According to a further exemplary embodiment of the present invention, a method of cooling a first electronic component and a second electronic component in an electronic cubicle device is provided. According to the method, a coolant is fed to a cooling channel in a heat exchanger body. The coolant is also drained from the cooling channel. A mounting surface of the heat exchanger body and an outer heat exchange surface of the heat exchanger body are cooled for cooling the first electronic component attached to the mounting surface and for cooling air surrounding the heat exchange surface. An air circulation of air surrounding the cooling device is provided by an air source connected to the heat exchanger body, so that an air flow of the air surrounding the cooling device is provided at the outer heat exchange surface. The air flow of the air surrounding the cooling device is guided to the outer heat exchange surface by an air guiding element connected to the heat exchanger body and/or to the air source. The first electronic component is attached to the mounting surface of the cooling device. The second electronic component is mounted to another location than the mounting surface within the electronic cubicle device in such a manner that a heat load of the second electronic component is transferred to the air surrounding the cooling device. The outer heat exchange surface of the cooling device is adapted for providing a heat exchange with the air surrounding the cooling device. By the term "mounting surface" a surface of the heat exchanger body may be described, to which the electronic component is mountable. The shape of the mounting surface may be formed in such a way that the surface is in close fitting or touching contact with a mounted electronic component in order to provide a proper heat transfer.

The term "outer heat exchange surface" may describe a surface or a section of the heat exchanger body that is in contact with the surrounding air, so that the heat transfer from the surrounding air to the outer heat exchange surface may be provided.

By the term "thermal contact" an installation of the cooling channel is described that provides a heat transmission from the mounting surface and the outer heat exchange surface. In particular, the cooling channel may be formed within a platelike heat exchanger body wherein heat from an upper mounting surface and heat from a lower heat exchange surface that is located at e.g. the opposite side of the heat exchanger body may be transferred to the coolant in the cooling channel.

Besides that, the heat exchanger body may also comprise the shape of a polyhedron with a plurality of surfaces, wherein each of the plurality of surfaces may form a heat exchanger surface or a mounting surface. Hence, the heat exchanger body may comprise more than one heat exchanger surface and/or mounting surface.

In particular, the mounting surface may be arranged vertically and e.g. with a power semi-conductor devices mounted to the right vertical hand face (mounting surface), and the air heat-exchanger fins attached or extruded from the left hand vertical face (heat exchanger surface). There may no particular restriction on which face is used for the various heat flow purposes, i.e. the location of the mounting surface and/or the heat exchanger surface. In particular, if more mounting surfaces are required for more power electronic or power semi-conductor devices then subject to machining and providing appropriate cooling channels in the vicinity of the mounting surface(s) this can be achieved. For cooling additional power semi-conductor devices, the heat exchanger surface may be machined, e.g. by machining away areas of the air heat-exchanger fins to provide a flat (or other shape as necessary) surface, to which the additional power semi-conductor devices can be attached.

In other words, when providing a cooling channel in thermal contact with the mounting surface and the outer heat exchange surface an integral design of the heat exchanger body may be described wherein both the mounting surface and the outer heat exchange surface transfers heat to a similar or the same section of the cooling channel. Thus, the mounting surface as well as the outer heat exchange surface are placed parallel to the cooling channel and not in series.

Thus, to the heat exchanger body only a feeding line connection and a draining line connection is necessary to provide a circulation of the coolant inside the cooling channel. Because the same cooling channel or section of the cooling channel is in thermal contact with both the mounting surface and the outer heat exchange surface, heat may be transferred to the same section of the coolant channel, so that no further line connections between the outer heat exchange surface and the mounting surface, i.e. between the water-cooling system and the air cooling system, have to be provided. Thus, a simple cooling system may be provided. Furthermore, by only providing two line connections, i.e. the feeding line connection and the draining line connection, a robust system may be provided because only two line connections have to be maintained. In other words, each line connection may provide a certain risk of leakage in such an electronic cubicle device. Thus, by reducing the amount of line connections for the cooling system also the risk of defect and leakage may be reduced. Thus, a more robust cooling device for electronic components is provided.

Furthermore, when installing a cooling device in (sealed) electronic cubicle devices, only two functional connections between the electronic cubicle device and the cooling device have to be provided, namely a functional connection for feeding the coolant to the cooling device and a functional connection for draining the coolant from the cooling device. Thus, a reduced amount of sealed functional connections in the outer shell of the sealed electronic cubicle device has to be provided.

For electronic cubicle devices incorporating more than 1 cooling device, then internal coolant distribution manifolds can be included so that at the electronic cubicle device level there are only two coolant connections - feeding and drainage connections - dimensioned for the coolant flow requirements of all the contained cooling devices. The internal distribution manifolds may then have sufficient ports for connection of feed lines and drainage lines from each of the cooling devices.

In a power converter system for a variable speed wind turbine comprising this invention, it is anticipated that 4 cooling devices will have to be incorporated into a single electronic cubicle device. The flow rate for the electronic cubicle device may be 160 litres/minute, and the flow rate for each individual cooling device may be 40 litres/minute. To keep the coolant temperature to each cooling device constant, the cooling devices are placed in parallel to the coolant flow. As each cooling device has the same pressure flow characteristic, then parallel connection is the most suitable.

In other power electronic systems where two cooling devices with differing internal structures and so possible different pressure flow characteristics are contained in the same electronic cubicle device, then a series connection of the coolant flow to the cooling devices within the electronic cubicle device may be desirable.

Summarizing, by the present invention, all cooling effects and optimization opportunities from a water-cooled chill plate as well as from an air-cooled heatsink (acting as a heat absorber) are brought together in one integral and integrally formed cooling device. Moreover, the amount of cooling interfaces and the amount of line connections are reduced so that the reliability may be increased. Moreover, a lower amount of parts of the integrated cooling device is necessary in comparison to a conventional assembly with the separated air to water heat-exchanger and the separated water cooled chill plate, so that lower overall system costs and overall weight may be provided. Next, the assembly time for the (integrated formed) cooling device may be reduced with the present invention because there is only one (integrated) cooling device to handle, whereby no interface cooling circuits between separate elements (as in conventional systems) may be necessary. Only the main flow (feeding line) and the return flow (draining line) connections for the coolants may be required for the (integrally formed) cooling device.

In the present invention, the air cooled heat-exchanger is operating as a heat-absorber from the air through the integrated heat-exchanger to the liquid coolant and onwards to the heat-exchanger external to the electronic cubicle.

The above-described cooling device for the electronic component may also be installed in the electronic cubicle device in an easy and simple manner. The electronic cubicle device may be sealed and may be adapted to be installed into arduous environmental conditions, for example saline environment and/or in a humid environment. The air inside the electronic cubicle device may be separated and sealed from the air surrounding the electronic cubicle device. Inside the electronic cubicle device the electronic device that comprises first electronic components attached to the mounting surface of the cooling device may be installed. Second electronic components may be placed to the cooling device or may be supported by the electronic cubicle device. The second electronic components transfer heat to the air that surrounds the second electronic components. The heat from the surrounding air of the second electronic components may be transferred to the outer heat exchange surface and transferred to the coolant.

Thus, by the electronic cubicle device comprising the above-described cooling device for the electronic first and second components, a simple and reliable cooling system may be installed.

According to a further exemplary embodiment of the present invention, the cooling device further comprises an air source connected to the heat exchanger body. The air source is adapted for providing an air circulation of air surrounding the cooling device, so that an airflow of the air surrounding the cooling device is provided at the outer heat exchange surface. The air source may comprise a fan, such as a centrifugal fan or an axial fan. By providing the air source, an (turbulent and/or higher velocity) airflow of the air surrounding the cooling device may be provided, so that the heat exchange rate between the outer heat exchange surface and the air surrounding the cooling device may be improved. Thus, more heat may be transferred to the coolant in the cooling channel from the surrounding air, so that a cooling efficiency may be improved.

According to a further exemplary embodiment, the air source is detachably connected to the heat exchanger body. Thus, the reliability of the cooling device may be improved because defective parts, either the heat exchanger body or the air source, may be exchanged easily without exchanging the complete cooling device. In particular, the air source may provide movable parts that are exposed to wear in comparison to the non-movable parts of the heat exchanger body. On the other side, heat exchanger body including the line connections and the cooling channel that may become leaky, so that also an exchange of the cooling device has to be necessary. Thus, by the detachably connected air source, a simpler maintenance and a cheaper exchange of defective parts may be provided.

According to a further exemplary embodiment, the cooling device further comprises an air guiding element that is connected to the heat exchanger body and/or to the air source. The air guiding element is adapted for guiding the airflow of the air surrounding the cooling device to the outer heat exchange surface. Thus, the air source respectively to the cooling capacity of the outer heat exchange surface may be improved because the airflow generated by the air source may be directly guided to the heat exchanger surface. Thus, the hotter air surrounding the cooling device is directed to the outer heat exchange surface, so that the hotter air is brought in thermal contact with the outer heat exchange surface efficiently. The air guiding element may be either connected to the air source or to the exchanger body. Thus, when exchanging the air source or the exchanger body, the air guiding elements may rest at the cooling device or vice versa and has not to be exchanged as well. Thus, maintenance costs may be reduced. Moreover, the air guiding elements may be formed integrally with the exchanger body and/or the air source.

According to a further exemplary embodiment, the geometry (e.g. the spacial positioning) of the cooling channel is adjusted to the position and the design of the electronic component. When producing the cooling device it may be already known which electronic components are placed to the mounting surface. Thus, it is already known which arrangement of electronic part is formed to the mounting surface and which shape and design the electronic components mounted to the mounting surface have. Thus, the geometry of the cooling channel may be formed with respect to the position and the design of the electronic components, so that the waste of cooling efficiency of the coolant may be reduced. In particular, below each electronic component the geometry (e.g. the spacial positioning) of the cooling channel may be formed, wherein below a free region of the mounting surface to which no electronic component is mounted, no cooling channel is provided.

According to a further exemplary embodiment, the cooling channel is formed in a meander-like shape. Thus, when providing the meander-like shape of the cooling channel, the cooling track of the coolant passing the region where an electronic component is placed may be enlarged. In other words, the coolant has more flow time below the electronic component, so that more heat from the electronic component may be transferred to the coolant and so that the cooling efficiency may be increased.

According to a further exemplary embodiment, the cooling device further comprises a heatsink. The heatsink is mounted to the mounting surface and may be located between the electronic components and the mounting surface. Thus, the electronic components may be pre-mounted to the heatsink and the complete assembly of the electronic components mounted to the heatsink may be installed to the mounting surface. Moreover, the exchange of the electronic components may be simplified because only the heatsink comprising the electronic components may be removed. Thus, maintenance time and costs may be reduced.

According to a further exemplary embodiment of the cooling device, on the outer heat exchange surface, fins are formed. By providing fins to the outer heat exchange surface the overall surface of the outer exchange surface may be increased, so that a larger contact surface with the surrounding air may be provided. Thus, the cooling efficiency may be increased because a larger contact area for the air surrounding the cooling device is available to transfer heat to the outer heat exchange surface and the coolant respectively.

According to a further exemplary embodiment of the electronic cubicle device, the electronic cubicle device comprises a further air source. The further air source may be adapted for providing within the electronic cubicle device an air circulation of the air surrounding the cooling device, so that an air flow of the air surrounding the cooling device is provided at the outer heat exchange surface. By providing a further air source supported by the electronic cubicle device, an airflow inside the electronic cubicle device may be provided independently from the function of the cooling device. Thus, it may be possible to provide one further air source for a plurality of cooling devices installed in the electronic cubicle device. Moreover, the cooling device may be exchanged without the need of exchanging the further air source too. The further air source may be located to different places with respect to the cooling device, so that a higher flexibility of the design of the electronic cubicle device may be provided.

According to a further exemplary embodiment, the electronic cubicle device is sealed for preventing a fluid exchange with an outer region of the electronic cubicle device. By the term "fluid exchange", an exchange of liquid fluids, such as water, and gaseous fluids, such as air, may be described, inside the electronic cubicle device air with only a small amount of humidity may be provided, so that no condensate formation inside the electronic cubicle device, caused for instance due to the cooling of the air surrounding the electronic components, may be generated.

According to a further exemplary embodiment, a plurality of first electronic components is attached to the mounting surface of the cooling device and/or a plurality of second electronic components is supported by the electronic cubicle device. Moreover, a plurality of cooling devices may be installed in the electronic cubicle device.

Moreover, the heat exchanger body may be formed of a billet (heat exchanger body) of aluminium that is extruded to include sufficient strength for the resulting assembly. Into the (metal) billet the cooling channels may be machined and at least two orifices through which coolant feeding line connection and coolant draining line connections to the cooling channels can be made.

In one exemplary embodiment, the cooling channels are closed by a mounting surface of the electronic components. In a further exemplary embodiment, the cooling channels are closed by a flat plate (heatsink) of aluminium which may be vacuum brazed to the aluminium extrusion. The resulting exposed surface of the closing plate (heatsink) may be machined to provide the necessary surface finish and fixing holes for the attachment of the electronic devices.

The face (heat exchange surface) of the billet (heat exchanger body) opposite to the face (mounting surface) where the cooling channels will be machined may be extruded to include castellated features into which flat aluminium plates which will act as the cooling fins may be attached either by press-fitting or by use of thermally conductive adhesive. Equivalently or alternatively, the cooling fins may be extruded as part of the billet so avoiding the press-fitting or thermally conductive adhesive step.

The coolant feeding line connection may be made to the bottom of one orifice with the other end of the same orifice being blanked off. Coolant draining line connection may be made to the top of the other orifice with the other end of the same orifice being blanked off.

The exemplary embodiments of the cooling device as explained in the above specification can also be applied to within an electronics assembly that is mountable into an electronic cubicle device. If the electronics assembly comprising single cooling device or a plurality of the cooling devices is itself sealed to IP55 or a better degree of protection and is then installed in an electronic cubicle device of e.g. IP21 then e.g. a salt laden or humid air may exist in the electronic cubicle device, but prevented from entering the electronics assembly by its higher degree of protection.

Within the electronics assembly there may be provided two generic types of heat source to be cooled - those attached to the chill plate (mounting surface), for example power semi-conductor devices, and those supported within the electronics assembly and not directly cooled by the chill plate. The heat from these components not directly cooled is carried by the air within the electronics assembly to the air cooling part (heat exchanger surface) of the integrated heat-exchanger either through natural convection or through a forced ventilation arrangement (air source) achieved by a fan.

In other words, the electronics assembly has the function of the electronic cubicle device as described above. Typically electrical components vulnerable to the environmental conditions external to the electronics assembly, for example printed circuit boards, will be contained within the protected (IP55) space of the electronics assembly, and components that are more rugged and do not need special environmental protection can be housed in the space of the electronic cubicle device. By this exemplary embodiment, the dimensioning of the fan (air source) and the air cooling part (heat exchanger surface) of the integrated heat-exchanger (cooling device) can be minimized with corresponding economies.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims is considered as to be disclosed with this application.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

Fig. 1 shows a schematic view of a cooling device and an electronic cubicle device according to an exemplary embodiment of the invention;
Fig. 2 illustrates a schematic view of a heat exchanger body according to an exemplary embodiment of the present invention;
Fig. 3 illustrates a schematic view of a heat exchanger body comprising fins according to an exemplary embodiment of the present invention;
Fig. 4 shows a schematic view of a cooling device including an air source according to an exemplary embodiment of the present invention;
Fig. 5 shows a schematic view of the embodiment shown in Fig. 4;
Fig. 6 shows a schematic perspective view of a cooling device according to an exemplary embodiment of the present invention;
Fig. 7 shows a schematic perspective view of a cooling device comprising a first and second coolant channel; and
Fig. 8 shows a conventional electronic cubicle device.

### Detailed Description

The illustration in the drawing is schematically drawn. It is noted that in different figures, similar or identical elements are provided with the same reference signs.

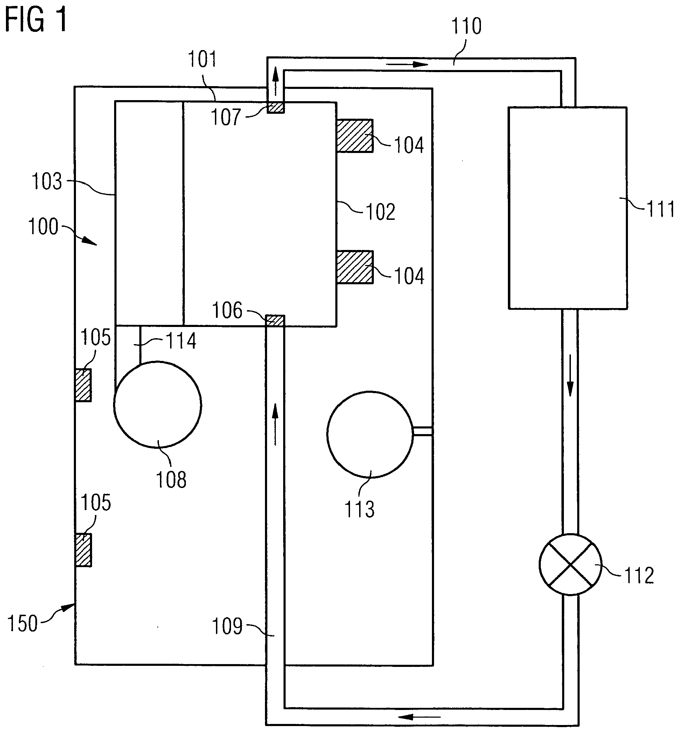

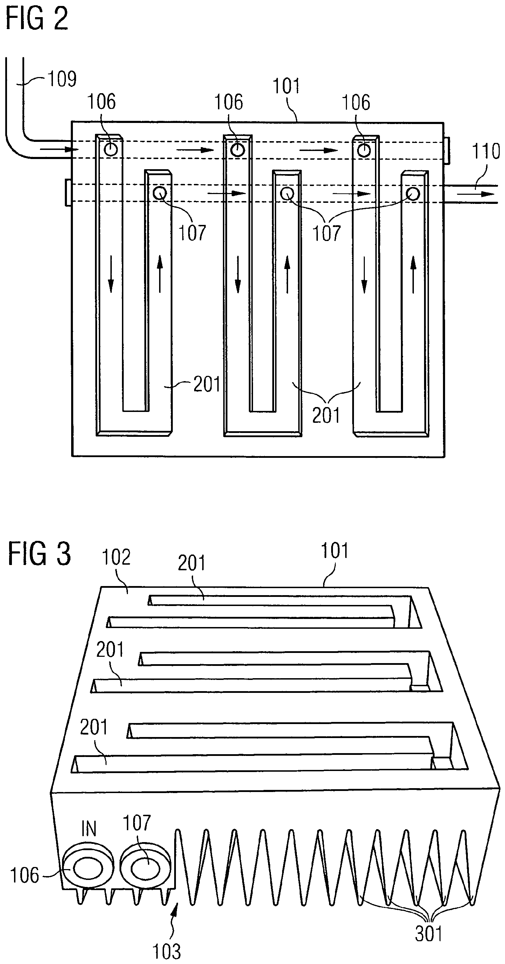

Fig. 1 illustrates a cooling device 100 for an electronic component 104. The cooling device 100 comprises a heat exchanger body 101. The heat exchanger body comprises a cooling channel 201 (shown in Fig. 2) for a coolant, a mounting surface 102 to which the first electronic component 104 is mountable and an outer heat exchange surface 103. The cooling device 100 further comprises a feeding line connection 106 for feeding the coolant and a draining line connection 107 for draining the coolant. The cooling channel 201 is interconnected to the feeding line connection 106 and the draining line connection 107. The cooling channel 201 is formed within the heat exchanger body 101 in such a way that the coolant in the cooling channel 201 is in thermal contact with the mounting surface 102 and the outer heat exchange surface 103 for providing a heat exchange.

The cooling device 100 may be installed inside the (sealed) electronic cubicle device 150. Inside the electronic cubicle device 150 first electronic components 104 and second electronic components 105 may be installed. The first electronic components 104 may be mounted to the mounting surface 102 of the cooling device 100, so that the first electronic components 104 may be water-cooled. The second electronic components 105 may be mounted to other locations than the mounting surface 102, such as to other surfaces of the heat exchanger body 101 or to the electronic cubicle device 150. The heat from the second electronic components 105 may be transferred to the air surrounding the electronic device 100 and the heat of the air surrounding the cooling device 100 may be transferred to the coolant by the outer heat exchange surface 103.

The coolant may be fed to the cooling channel 201 by a feeding line 109 connected to the feeding line connection 106. After transferring heat to the coolant, the coolant may be drained off from the cooling device 100 by a draining line 110 connected to the draining line connection 107. The feeding line 109 may take the coolant from a reservoir, such as a sea or a container. Moreover, the coolant may flow in a coolant circulation. Thereby the drained coolant in the draining line 110 may flow to an external heat exchanger 111, so that the coolants may be cooled down. Next, the cooled coolant may be fed by the feeding line 109 back to the cooling device 100 for gathering heat from the electronic components 104, 105 again. The coolant circulation may be driven by a pump 112 that may be located outside or inside the electronic cubicle device 150.

In Fig. 1 it is furthermore shown an air source 108 that may comprise an axial fan or a centrifugal fan. The air source 108 may provide an airflow to the outer heat exchange surface 103. Between the exhaust location of air of the air source 108 and the outer heat exchange surface 103, an air guiding element 114 may be located, so that the air surrounding the cooling device 100 may be directly directed to the outer heat exchange surface 103 for providing a more effective heat transfer from the air to the cooling device 100. The air source 108 may be detachably connected to the cooling device 100.

Moreover, a further air source 113 is shown that may be supported by the electronic cubicle device 150. Thus, an airflow inside the electronic cubicle device 150 may be generated. Thus, the further air source 113 may provide an airflow for a plurality of cooling devices 100 that may be installed inside the electronic cubicle device 150.

Fig. 2 illustrates a top view of the heat exchanger body 101. Inside the heat exchanger body 101 the cooling channel 201 is shown. As can be seen in Fig. 2, also a plurality of separate cooling channels 201 may be formed inside the heat exchanger body 101. The cooling channel 201 may be formed inside the heat exchanger body 101 or may be attached as a separate part to the heat exchanger body 101. The cooling channel 201 may be formed integrally in the heat exchanger body 101. Each cooling channel 201 may be connected to the (same) feeding line 109 by the feeding line connection 106 and may be connected to the (same) draining line 110 by the draining line connection 107. Each feeding line 109 may be connected to a plurality of cooling channels 201 and each draining line 110 may be connected to a plurality of cooling channels 201.

Fig. 3 illustrates a perspective view of the heat exchanger body 101 comprising fins 301. The fins 301 may be formed integrally and may extrude from the outer heat exchange surface 103. Moreover, the fins 301 may also be attached individually to the outer heat exchange surface 103 and may be connected to the outer heat exchange surface 103, for instance by press-fit or with thermally conductive adhesive into castellated features formed in the basic (e.g. aluminium) billet of the heat exchanger body 101. Moreover, in Fig. 3, the feeding line connection 106 and the draining line connection 107 are shown. The interface of the feeding line connection 106 and the draining line connection 107 to the respective feeding line 109 and draining line 110 may be installed in one side or faced of the heat exchanger body 101, so that an easy installation of the cooling device 100 in a possibly tight electronic cubicle device 150 may be provided.

Each cooling channel 201 may provide a meander-like shape, so that the overall length of the cooling line respectively of the cooling channel 201 may be enlarged, so that the coolant has more time to absorb heat from the first electronic components 104 mounted to the mounting surface 102 and the heat exchanger body 101, respectively. Moreover, the cooling channels 201 may be adapted with its specific geometry to the position and the design of electronic components 104. Only where the electronic components 104 are installed to the mounting surface 102 the cooling channels 102 are formed. Thus, the cooling efficiency may be improved.

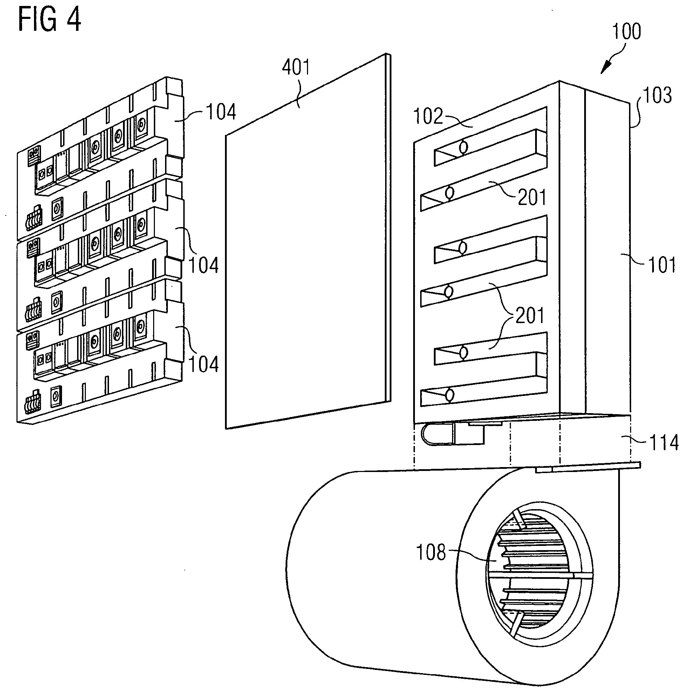

Fig. 4 illustrates a perspective view of an exemplary embodiment of the cooling device 100. The air source 108 may comprise a centrifugal fan that blows air surrounding the cooling device 100 by the air guiding element 114 to the outer heat exchange surface 103. Heat from the air surrounding the cooling device 100 may be transferred to the cooling channels 201 formed in the heat exchanger body 101. To the opposed side or faced of the outer heat exchange surface 103 the mounting surface 102 is shown to which the first electronic components 104 may be mounted. Between the first electronic components 104 and the mounting surface 102 a heatsink 401 may be placed. To the heatsink 401 a pre-assembled first electronic component arrangement 104 may be pre-assembled, so that in one installation step the heatsink 401 may be mounted to the mounting surface 102. Thus, an easier installation of the cooling device 100 may be provided.

In a further exemplary embodiment, the heatsink 401 may be vacuum brazed to the mounting surface 102, so that the vacuum brazed the heatsink 401 may be a part of the heat exchanger body 101 and the mounting surface 102 may define the outer face of the heatsink 401 to which the first electronic components 104 may be mounted. The complete cooling device 100 may then be pressure tested to ensure that it is not leaking. The first electronic components 104 are then mounted to the outer face of the heatsink 401. In order to improve the leak tightness, sealing elements or coolant seals may be introduced between the heat exchanger body 101 and the heatsink 401.

The first electronic components 104, such as power semi-conductor devices, could in an exemplary embodiment be mounted directly above the meanders and are in direct contact with their mounting face and the mounting surface 102 and with the coolant. The mounting face of the first electronic component 104 may provide a sufficient strength to resist the pressure of the coolant. Moreover, the mounting face of the first electronic component 104 may be finished (for example plated), so that the coolant does not interfere the function or degrade the mounting face of the first electronic component 104.

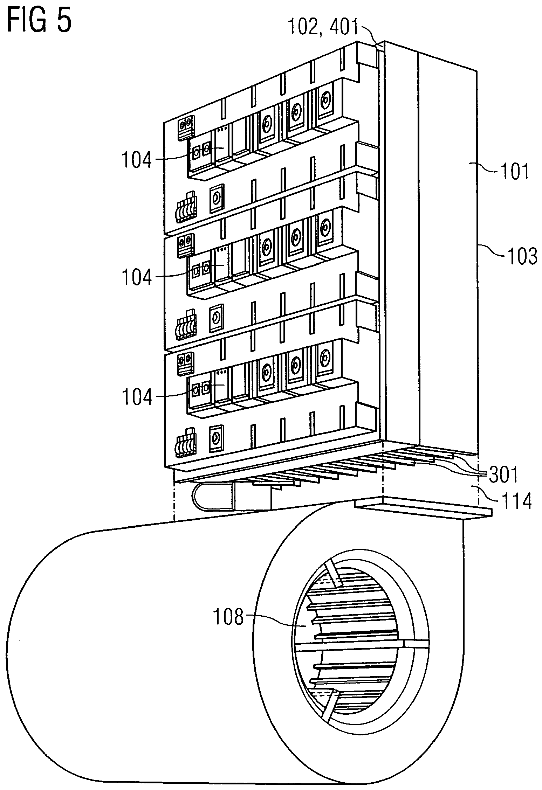

Fig. 5 illustrates a perspective view of the cooling device 100 as shown in Fig. 4. In Fig. 5 the fins 301 are shown in more detail. The airflow of the air surrounding the cooling device 100 is blown by the air source 108 and directed by the air guiding element 114 to the fins 301 for improving the cooling capacity of the cooling device 100.

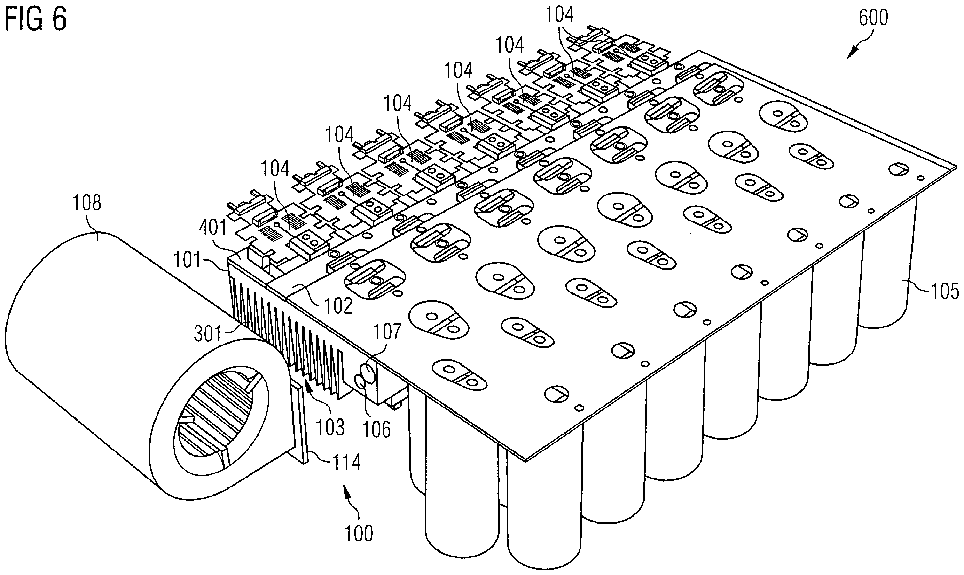

Fig. 6 illustrates a perspective view of the cooling device 100, incorporated into a complete electronic assembly 600 for the function say of a 4 quadrant inverter intended for a renewable energy application such as a wind turbine, wherein first electronic components 104 are installed to the cooling device 100 and second electronic components 105 are installed to the complete assembly 600. The first electronic components 104 are mounted to the mounting surface 102 of the heat exchanger body 101. The mounting surface 102 is adapted for transferring the heat from the first electronic components 104 through the vacuum brazed plate 401 to the coolant in the cooling channel 201. Moreover, second electronic components 105 are installed at locations of the complete electronic assembly 600 that are not in direct contact with the coolant or the cooling channel 201 or the cooling device 100, so that no direct thermal contact is provided with the coolant. The heat generated by the second electronic component 105 is transferred to air surrounding the cooling device 100. The air source 108 generates an air circulation and an airflow of the air surrounding the second electronic component 105. The air guiding element 114 guides the airflow directly to the fins 301 of the outer heat exchange surface 103. Thus, because the outer heat exchange surface 103 is in thermal contact with the coolant in the cooling channel 201 through the thermally conductive heat exchanger body (billet) 101 forming the cooling device 100, the heat of the air surrounding the cooling device 100 is transferred to the coolant respectively the cooling channel 201. As shown in Fig. 6, the air source 108 may be detachably connected to heat exchanger body 101.

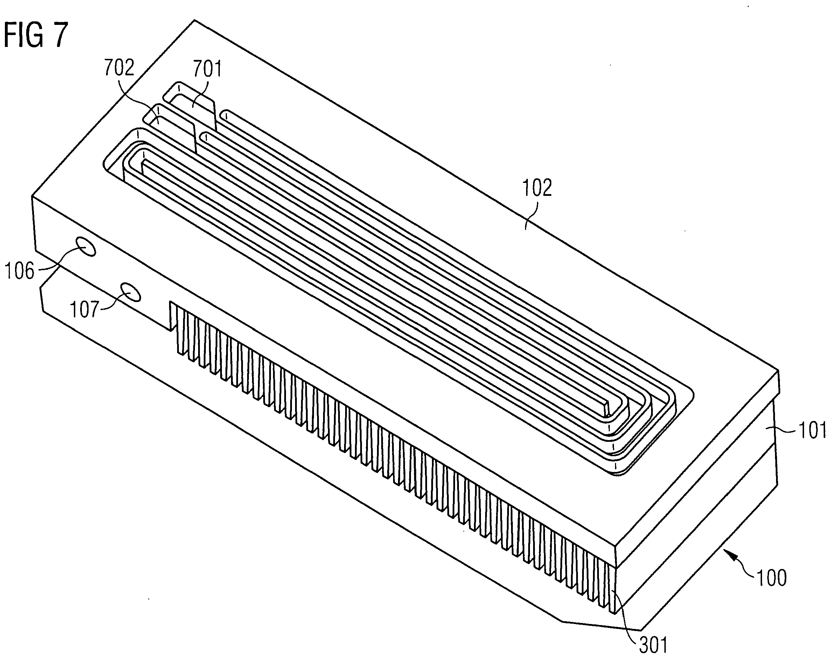

Fig.7 shows a schematic perspective view of the cooling device 100 comprising a first coolant channel 701 and second coolant channel 702. Both cooling channels 701, 702 form a meander like shape and are engaged or meshed in a twin track 'race-way' configuration. Each coolant channel 701, 702 is connected to the feeding line connection 106 and the draining line connection 107. The meander like shape of both coolant channels 701, 702 is intended to act as an averaging arrangement of both cooling channels 701, 702 so that there is a better heat-exchange between the electronic component 104 and the coolant.

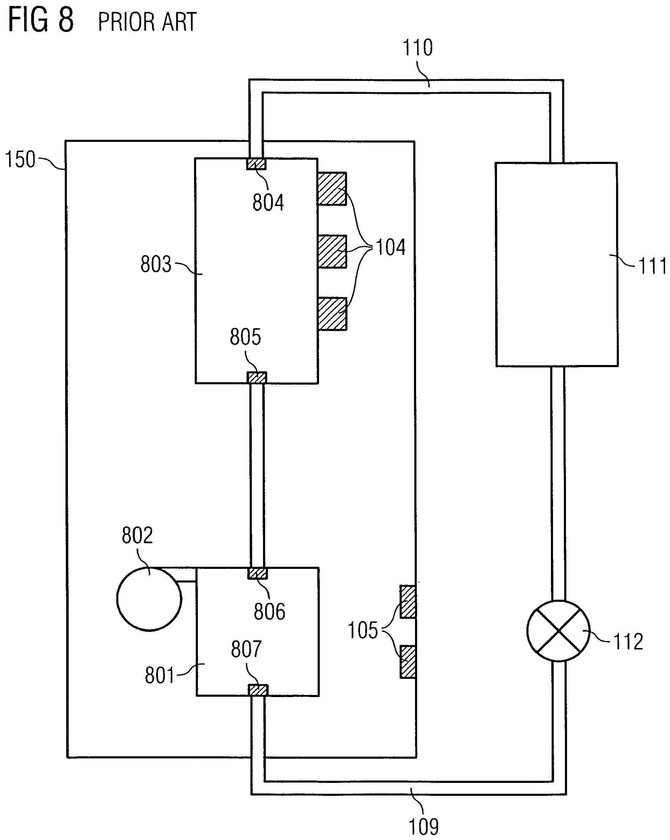

Fig. 8 illustrates a conventional cooling system of an electronic cubicle device 150. Inside the electronic cubicle device 150 an internal heat exchanger 801, an internal fan 802 and a chill plate 803 is located. The internal heat exchanger 801 with its internal fan 802 are adapted for providing a heat exchange between air inside the electronic cubicle device and a coolant flowing in the feeding line 109 and the draining line 110. Separate to the internal heat exchanger 801 and placed in series to the internal heat exchanger 801 the chill plate 103 is installed. Inside the chill plate the coolant may flow and may absorb heat from the first electronic components that are located to a surface of the chill plate 803. Each of the separated internal heat exchanger 801 and chill plates 803 provides a coolant connection. Thus, as can be seen in Fig. 8, a first cooling connection is provided for feeding coolant to the internal heat exchanger 801 and a second cooling connection 805 is provided for draining the coolant from the internal heat exchanger 801. Next, the coolant is fed to the chill plate 803 by a third cooling connection 106 and is drained off from the chill plate 803 by a fourth cooling connection 107. As can be seen from Fig. 8, a plurality of cooling connections and a plurality of separated parts have to be installed inside the electronic cubicle device 150, so that the reliability may be reduced and the overall system complexity may be increased.

## Claims

1. An electronic cubicle device, comprises a first electronic component (104),
a second electronic component (105),
a cooling device (100) comprising
a heat exchanger body (101) comprising a cooling channel (201) for a coolant, a mounting surface (102) to which the first electronic component is mounted and an outer heat exchange surface (103),
a feeding line connection (106) for feeding the coolant,
a draining line connection (107) for draining the coolant,
an air source (108) connected to the heat exchanger body (101), and
an air guiding element (114) connected to the heat exchanger body (101) and/or to the air source (108),
wherein the cooling channel (201) is interconnected to the feeding line connection (106) and the draining line connection (107), and
wherein the cooling channel (201) is formed within the heat exchanger body (101) in such a way that the coolant in the cooling channel (201) is in thermal contact with the mounting surface (102) and the outer heat exchange surface (103) for providing a heat exchange,
wherein the air source (108) is adapted for providing an air circulation of air surrounding the cooling device (100), so that an air flow of the air surrounding the cooling device (100) is provided at the outer heat exchange surface (103),
wherein the air guiding element (114) is adapted for guiding the air flow of the air surrounding the cooling device (100) to the outer heat exchange surface (103),
wherein the first electronic component (104) is attached to the mounting surface (102) of the cooling device (100),
wherein the second electronic component (105) is mounted to another location than the mounting surface (102) within the electronic cubicle device (150) in such a manner that a heat load of the second electronic component (105) is transferred to the air surrounding the cooling device (100) and
wherein the outer heat exchange surface (103) of the cooling device (100) is adapted for providing a heat exchange with the air surrounding the cooling device (100).

2. The electronic cubicle device of claim 1,
wherein the air source (108) is detachably connected to the heat exchanger body (101).

3. The electronic cubicle device of claim 1 or 2,
wherein the air source (108) comprises a centrifugal fan or an axial fan.

4. The electronic cubicle device of one of the claims 1 to 3,
wherein the geometry of the cooling channel (201) is adjusted to the position and the design of the first electronic component (104).

5. The electronic cubicle device of one of the claims 1 to 4,
wherein the cooling channel (201) is formed in a meander like shape.

6. The electronic cubicle device of one of the claims 1 to 5, further comprising
a heatsink (401),
wherein the heatsink (401) is mounted to the mounting surface (102).

7. The electronic cubicle device of one of the claims 1 to 6,
wherein on the outer heat exchange surface (103) fins (301) are formed.

8. The electronic cubicle device of one of claims 1 to 7, further comprising
a further air source (113), which is adapted for providing within the electronic cubicle device (150) an air circulation of air surrounding the cooling device (100), so that an air flow of the air surrounding the cooling device (100) is provided at the outer heat exchange surface (103).

9. The electronic cubicle device of one of claims 1 to 8,
wherein the electronic cubicle device (150) is sealed for preventing a fluid exchange with an outer region of the electronic cubicle device (150).

10. The electronic cubicle device of one of the claims 1 to 9,
wherein a plurality of first electronic components (104) is attached to the mounting surface (102) of the cooling device (100), and/or a plurality of second electronic components (105) is supported by the electronic cubicle device (150).

11. A method of cooling a first electronic component (104) and a second electronic component (105) in an electronic cubicle device, the method comprising
feeding coolant to a cooling channel (201) in a heat exchanger body (101),
draining coolant from the cooling channel (201),
cooling a mounting surface (102) of the heat exchanger body (101) and cooling an outer heat exchange surface (103) of the heat exchanger body (101) for cooling the first electronic component (104) attached to the mounting surface (102) and for cooling air surrounding the outer heat exchange surface (103),
providing an air circulation of air surrounding the cooling device (100) by an air source (108) connected to the heat exchanger body (101), so that an air flow of the air surrounding the cooling device (100) is provided at the outer heat exchange surface (103),
guiding the air flow of the air surrounding the cooling device (100) to the outer heat exchange surface (103) by an air guiding element (114) connected to the heat exchanger body (101) and/or to the air source (108),
wherein the first electronic component (104) is attached to the mounting surface (102) of the cooling device (100),
wherein the second electronic component (105) is mounted to another location than the mounting surface (102) within the electronic cubicle device (150) in such a manner that a heat load of the second electronic component (105) is transferred to the air surrounding the cooling device (100), and
wherein the outer heat exchange surface (103) of the cooling device (100) is adapted for providing a heat exchange with the air surrounding the cooling device (100).

## Patentansprüche

1. Elektronikschrankvorrichtung, umfassend ein erstes elektronisches Bauteil (104),
ein zweites elektronisches Bauteil (105),
eine Kühlvorrichtung (100), die Folgendes umfasst:
einen Wärmetauscherkörper (101), umfassend einen Kühlkanal (201) für ein Kühlmittel, eine Montageoberfläche (102), an der das erste elektronische Bauteil angebracht ist, und eine äußere Wärmeaustauschfläche (103),
eine Zufuhrleitungsverbindung (106) zum Zuführen des Kühlmittels,
eine Abfuhrleitungsverbindung (107) zum Abführen des Kühlmittels,
eine mit dem Wärmetauscherkörper (101) verbundene Luftquelle (108),
ein mit dem Wärmetauscherkörper (101) und/oder mit der Luftquelle (108) verbundenes Luftleitelement (114),
wobei der Kühlkanal (201) mit der Zufuhrleitungsverbindung (106) und der Abfuhrleitungsverbindung (107) verbunden ist,
wobei der Kühlkanal (201) innerhalb des Wärmetauscherkörpers (101) derart ausgebildet ist, dass das Kühlmittel in dem Kühlkanal (201) in thermischem Kontakt mit der Montageoberfläche (102) und der äußeren Wärmeaustauschfläche (103) steht, um einen Wärmeaustausch zu ermöglichen,
wobei die Luftquelle (108) dazu ausgebildet ist, eine Luftzirkulation von die Kühlvorrichtung (100) umgebender Luft zu ermöglichen, sodass ein Luftstrom der die Kühlvorrichtung (100) umgebenden Luft an der äußeren Wärmeaustauschfläche (103) ermöglicht wird,
wobei das Luftleitelement (114) dazu ausgebildet ist, den Luftstrom der die Kühlvorrichtung (100) umgebenden Luft zu der äußeren Wärmeaustauschfläche (103) zu lenken,
wobei das erste elektronische Bauteil (104) an der Montageoberfläche (102) der Kühlvorrichtung (100) befestigt ist,
wobei das zweite elektronische Bauteil (105) an einer anderen Stelle als der Montageoberfläche (102) innerhalb der Elektronikschrankvorrichtung (150) derart angebracht ist, dass eine Wärmelast des zweiten elektronischen Bauteils (105) an die die Kühlvorrichtung (100) umgebende Luft übertragen wird, und
wobei die äußere Wärmeaustauschfläche (103) der Kühlvorrichtung (100) dazu ausgebildet ist, einen Wärmeaustausch mit der die Kühlvorrichtung (100) umgebenden Luft zu ermöglichen.

2. Elektronikschrankvorrichtung nach Anspruch 1,
wobei die Luftquelle (108) lösbar mit dem Wärmetauscherkörper (101) verbunden ist.

3. Elektronikschrankvorrichtung nach Anspruch 1 oder 2,
wobei die Luftquelle (108) einen Radiallüfter oder einen Axiallüfter umfasst.

4. Elektronikschrankvorrichtung nach einem der Ansprüche 1 bis 3,
wobei die Geometrie des Kühlkanals (201) an die Position und die Ausgestaltung des ersten elektronischen Bauteils (104) angepasst ist.

5. Elektronikschrankvorrichtung nach einem der Ansprüche 1 bis 4,
wobei der Kühlkanal (201) mäanderförmig ausgebildet ist.

6. Elektronikschrankvorrichtung nach einem der Ansprüche 1 bis 5, ferner umfassend
einen Wärmeableiter (401),
wobei der Wärmeableiter (401) an der Montageoberfläche (102) angebracht ist.

7. Elektronikschrankvorrichtung nach einem der Ansprüche 1 bis 6,
wobei auf der äußeren Wärmeaustauschfläche (103) Rippen (301) gebildet sind.

8. Elektronikschrankvorrichtung nach einem der Ansprüche 1 bis 7, ferner umfassend
eine weitere Luftquelle, die dazu ausgebildet ist, innerhalb der Elektronikschrankvorrichtung (150) eine Luftzirkulation von die Kühlvorrichtung (100) umgebender Luft zu ermöglichen, sodass ein Luftstrom der die Kühlvorrichtung (100) umgebenden Luft an der äußeren Wärmeaustauschfläche (103) ermöglicht wird.

9. Elektronikschrankvorrichtung nach einem der Ansprüche 1 bis 8,
wobei die Elektronikschrankvorrichtung (150) zur Vermeidung eines Flüssigkeitsaustauschs mit einem äußeren Bereich der Elektronikschrankvorrichtung (150) abgedichtet ist.

10. Elektronikschrankvorrichtung nach einem der Ansprüche 1 bis 9,
wobei eine Mehrzahl von ersten elektronischen Bauteilen (104) an der Montageoberfläche (102) der Kühlvorrichtung (100) befestigt ist und/oder eine Mehrzahl von zweiten elektronischen Bauteilen (105) von der Elektronikschrankvorrichtung (150) unterstützt wird.

11. Verfahren zum Kühlen eines ersten elektronischen Bauteils (104) und eines zweiten elektronischen Bauteils (105) in einer Elektronikschrankvorrichtung, wobei das Verfahren Folgendes umfasst:
Zuführen von Kühlmittel zu einem Kühlkanal (201) in einem Wärmetauscherkörper (101),
Abführen von Kühlmittel aus dem Kühlkanal (201),
Kühlen einer Montageoberfläche (102) des Wärmetauscherkörpers (101) und Kühlen einer äußeren Wärmeaustauschfläche (103) des Wärmetauscherkörpers (101) zum Kühlen des an der Montageoberfläche (102) befestigten ersten elektronischen Bauteils (104) und zum Kühlen von die äußere Wärmeaustauschfläche (103) umgebender Luft,
Ermöglichen einer Luftzirkulation von die Kühlvorrichtung (100) umgebender Luft durch eine mit dem Wärmetauscherkörper (101) verbundenen Luftquelle (108), sodass ein Luftstrom der die Kühlvorrichtung (100) umgebenden Luft an der äußeren Wärmeaustauschfläche (103) ermöglicht wird,
Lenken des Luftstroms der die Kühlvorrichtung (100) umgebenden Luft zu der äußeren Wärmeaustauschfläche (103) durch ein mit dem Wärmetauscherkörper (101) und/oder mit der Luftquelle (108) verbundenes Luftleitelement (114),
wobei das erste elektronische Bauteil (104) an der Montageoberfläche (102) der Kühlvorrichtung (100) befestigt ist,
wobei das zweite elektronische Bauteil (105) an einer anderen Stelle als der Montageoberfläche (102) innerhalb der Elektronikschrankvorrichtung (150) derart angebracht ist, dass eine Wärmelast des zweiten elektronischen Bauteils (105) an die die Kühlvorrichtung (100) umgebende Luft übertragen wird, und
wobei die äußere Wärmeaustauschfläche (103) der Kühlvorrichtung (100) dazu ausgebildet ist, einen Wärmeaustausch mit der die Kühlvorrichtung (100) umgebenden Luft zu ermöglichen.

## Revendications

1. Dispositif d'armoire électronique, comprenant
un premier composant électronique (104),
un deuxième composant électronique (105),
un dispositif de refroidissement (100) comprenant
un corps échangeur de chaleur (101) comprenant un canal de refroidissement (201) pour un fluide de refroidissement, une surface de montage (102) sur laquelle le premier composant électronique est monté et une surface d'échange de chaleur externe (103),
un raccord de conduite d'alimentation (106) pour alimenter le fluide de refroidissement,
un raccord de conduite d'évacuation (107) pour évacuer le fluide de refroidissement,
une source d'air (108) raccordée au corps échangeur de chaleur (101), et
un élément de guidage d'air (114) raccordé au corps échangeur de chaleur (101) et/ou à la source d'air (108),
dans lequel le canal de refroidissement (201) est raccordé au raccord de conduite d'alimentation (106) et au raccord de conduite d'évacuation (107), et
dans lequel le canal de refroidissement (201) est formé à l'intérieur du corps échangeur de chaleur (101) de sorte que le fluide de refroidissement dans le canal de refroidissement (201) soit en contact thermique avec la surface de montage (102) et la surface d'échange de chaleur externe (103) pour assurer un échange de chaleur,
dans lequel la source d'air (108) est adaptée pour assurer une circulation d'air de l'air entourant le dispositif de refroidissement (100), de sorte qu'un flux d'air de l'air entourant le dispositif de refroidissement (100) soit fourni au niveau de la surface d'échange de chaleur externe (103),
dans lequel l'élément de guidage d'air (114) est adapté pour guider le flux d'air de l'air entourant le dispositif de refroidissement (100) jusqu'à la surface d'échange de chaleur externe (103),
dans lequel le premier composant électronique (104) est fixé à la surface de montage (102) du dispositif de refroidissement (100),
dans lequel le deuxième composant électronique (105) est monté sur un autre emplacement que la surface de montage (102) à l'intérieur du dispositif d'armoire électronique (150) de manière à ce qu'une charge calorifique du deuxième composant électronique (105) soit transférée à l'air entourant le dispositif de refroidissement (100), et
dans lequel la surface d'échange de chaleur externe (103) du dispositif de refroidissement (100) est adaptée pour assurer un échange de chaleur avec l'air entourant le dispositif de refroidissement (100).

2. Dispositif d'armoire électronique selon la revendication 1,
dans lequel la source d'air (108) est raccordée de manière amovible au corps échangeur de chaleur (101).

3. Dispositif d'armoire électronique selon la revendication 1 ou 2,
dans lequel la source d'air (108) comprend un ventilateur centrifuge ou un ventilateur axial.

4. Dispositif d'armoire électronique selon l'une des revendications 1 à 3,
dans lequel la géométrie du canal de refroidissement (201) est ajustée à la position et à la conception du premier composant électronique (104).

5. Dispositif d'armoire électronique selon l'une des revendications 1 à 4,
dans lequel le canal de refroidissement (201) se présente sous la forme d'un méandre.

6. Dispositif d'armoire électronique selon l'une des revendications 1 à 5, comprenant en outre
un dissipateur thermique (401),
dans lequel le dissipateur thermique (401) est monté sur la surface de montage (102).

7. Dispositif d'armoire électronique selon l'une des revendications 1 à 6,
dans lequel, des ailettes (301) sont formées sur la surface d'échange de chaleur externe (103).

8. Dispositif d'armoire électronique selon l'une des revendications 1 à 7, comprenant en outre
une source d'air supplémentaire (113), qui est adaptée pour assurer à l'intérieur du dispositif d'armoire électronique (150) une circulation d'air de l'air entourant le dispositif de refroidissement (100), de sorte qu'un flux d'air de l'air entourant le dispositif de refroidissement (100) soit fourni au niveau de la surface d'échange de chaleur externe (103) .

9. Dispositif d'armoire électronique selon l'une des revendications 1 à 8,
dans lequel le dispositif d'armoire électronique (150) est scellé pour empêcher un échange de fluide avec une région extérieure du dispositif d'armoire électronique (150).

10. Dispositif d'armoire électronique selon l'une des revendications 1 à 9,
dans lequel une pluralité de premiers composants électroniques (104) est fixée à la surface de montage (102) du dispositif de refroidissement (100), et/ou une pluralité de deuxièmes composants électroniques (105) est supportée par le dispositif d'armoire électronique (150).

11. Procédé de refroidissement d'un premier composant électronique (104) et d'un deuxième composant électronique (105) dans un dispositif d'armoire électronique, le procédé comprenant les étapes consistant
à alimenter en fluide de refroidissement un canal de refroidissement (201) dans un corps échangeur de chaleur (101),
à évacuer le fluide de refroidissement du canal de refroidissement (201),
à refroidir une surface de montage (102) du corps échangeur de chaleur (101) et à refroidir une surface d'échange de chaleur externe (103) du corps échangeur de chaleur (101) pour refroidir le premier composant électronique (104) fixé à la surface de montage (102) et pour refroidir l'air entourant la surface d'échange de chaleur externe (103),
à assurer une circulation d'air de l'air entourant le dispositif de refroidissement (100) par une source d'air (108) raccordée au corps échangeur de chaleur (101), de sorte qu'un flux d'air de l'air entourant le dispositif de refroidissement (100) soit fourni au niveau de la surface d'échange de chaleur externe (103),
à guider le flux d'air de l'air entourant le dispositif de refroidissement (100) jusqu'à la surface d'échange de chaleur externe (103) par un élément de guidage d'air (114) raccordé au corps échangeur de chaleur (101) et/ou à la source d'air (108),
dans lequel le premier composant électronique (104) est fixé à la surface de montage (102) du dispositif de refroidissement (100),
dans lequel le deuxième composant électronique (105) est monté sur un autre emplacement que la surface de montage (102) à l'intérieur du dispositif d'armoire électronique (150) de manière à ce qu'une charge calorifique du deuxième composant électronique (105) soit transférée à l'air entourant le dispositif de refroidissement (100), et
dans lequel la surface d'échange de chaleur externe (103) du dispositif de refroidissement (100) est adaptée pour assurer un échange de chaleur avec l'air entourant le dispositif de refroidissement (100).
